# EUROPÄISCHE PATENTSCHRIFT

(11) **EP 0 330 895 B1**
(45) Veröffentlichungstag und Bekanntmachung des Hinweises auf die Patenterteilung: **14.12.1994**
(21) Anmeldenummer: 89102447.3
(22) Anmeldetag: 13.02.1989
(51) Int. Cl.: H01L 21/603, B30B 15/02

(54) **Verfahren zum Befestigen von elektronischen Bauelementen auf Substraten und Anordnung zur Durchführung desselben**
Method for attaching electronic components to substrates, and arrangement for carrying it out
Procédé pour fixer des composants électroniques sur des substrats et dispositif pour sa réalisation

(30) Priorität: 03.03.1988 DE 3806979
(43) Veröffentlichungstag der Anmeldung: 06.09.1989
(73) Patentinhaber: SIEMENS AKTIENGESELLSCHAFT, 80333 München (DE)
(72) Erfinder: Schwarzbauer, Herbert, Dr.rer.nat., D-8000 München 70 (DE)

(56) Entgegenhaltungen:
- EP-A- 0 242 626
- BE-A- 896 207

## Beschreibung

Die Erfindung bezieht sich auf ein verfahren zum Befestigen von elektronischen Bauelementen, insbesondere großflächigen Leistungshalbleitern, auf Substraten durch Drucksintern nach dem Oberbegriff des Patentanspruchs 1 und auf eine Anordnung zur Durchführung desselben.

Ein solches Drucksinterverfahren ist aus der EP-A 0 242 626 bekannt. Dabei werden beim Einbringen einer aus einem Substrat und einem Bauelement bestehenden Anordnung in die Presse zwischen der Oberseite des Bauelements und dem einen Pressenstempel eine erste Zwischenlage aus Aluminium und eine zweite Zwischenlage aus Molybdän vorgesehen, um die Bauelementoberseite während des eigentlichen Preßvorgangs vor mechanischen Beschädigungen zu schützen. Bei Bauelementen mit strukturierter bzw. zerklüfteter Oberseite führt aber der Preßvorgang auch bei Verwendung dieser Zwischenlagen zu starken Verspannungen im Halbleiterkörper, die eine Zerstörung des Bauelements zur Folge haben können.

Der Erfindung liegt die Aufgabe zugrunde, ein Verfahren der eingangs genannten Art anzugeben, mit dem auch Bauelemente mit strukturierter oder zerklüfteter Oberseite auf einem Substrat befestigt werden können, ohne daß mechanische Beschädigungen des Bauelements oder seiner Oberseite hervorgerufen werden. Das wird erfindungsgemäß durch eine Ausbildung des Verfahrens nach dem kennzeichnenden Teil des Patentanspruchs 1 erreicht.

Der mit der Erfindung erzielbare Vorteil besteht insbesondere darin, daß der Körper aus temperaturbeständigem, elastisch verformbaren Material den erforderlichen Druck auch bei starker Strukturierung der Oberseite des Bauelements völlig gleichmäßig auf die miteinander zu verbindenden Teile überträgt, so daß eine gleichmäßige und dauerhafte Verbindung des Bauelements mit dem Substrat erzielt wird.

Die Ansprüche 2 bis 10 beziehen sich auf eine zur Durchführung des erfindungsgemäßen Verfahrens geeignete Anordnung.

Die Erfindung wird nachfolgend anhand der Zeichnung näher erläutert. Dabei zeigt:
- Fig. 1: ein Halbleiterbauelement und ein Substrat im Querschnitt,
- Fig. 2: eine zur Durchführung des erfindungsgemäßen Verfahrens geeignete Anordnung,
- Fig. 3: die Anordnung nach Fig. 2 während der Druckübertragung auf die aus Substrat und Halbleiterbauelement bestehende Anordnung und
- Fig. 4: eine weitere zur Durchführung des erfindungsgemäßen Verfahrens geeignete Anordnung.

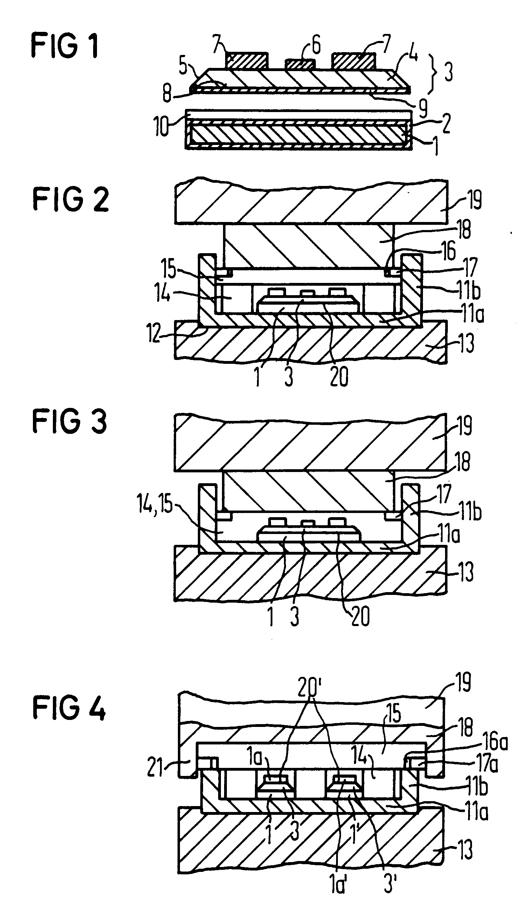

In Fig. 1 ist ein Substrat 1 dargestellt, bei dem es sich z.B. um eine 1,5 mm starke Scheibe aus Molybdän mit einem Durchmesser von etwa 29,6 mm handelt. Diese ist allseitig mit einer galvanisch aufgetragenen Kontaktschicht 2 versehen, die etwa 2 bis 3 µm dick ist und z.B. aus Silber besteht. Mit 3 ist ein Halbleiterbauelement bezeichnet, das auf dem Substrat 1 befestigt werden soll. Es besteht z.B. aus einem Thyristor mit einem Siliziumkörper 4, dessen seitlicher Rand 5 abgeschrägt ist. Auf der Oberseite des Siliziumkörpers 5 befinden sich eine Elektrode 6, die zur Zündung und gegebenenfalls zum Löschen des Thyristors dient, sowie eine kathodenseitige Elektrode 7. Nach der Verbindung des Thyristors 3 mit dem Substrat 1 bildet das letztere die anodenseitige Elektrode. Die Unterseite 8 des Siliziumkörpers 4 ist mit einer Schichtfolge überzogen, die im einzelnen aus einer etwa 1 µm starken Aluminiumschicht, einer auf dieser aufgetragenen, etwa 100 nm dicken Titanschicht, einer über dieser liegenden, etwa 500 nm dicken Mittelschicht, zB. aus Nickel oder Platin, und schließlich einer diese abdeckenden, etwa 200 nm starken Silberschicht besteht. In Fig. 1 ist lediglich die als Kontaktierungsschicht dienende Silberschicht dargestellt und mit 9 bezeichnet.

Zum Befestigen des Bauelements 3 auf dem Substrat 1 wird so vorgegangen, daß auf der Kontaktschicht 2 eine Paste 10 schichtförmig, und zwar mit einer Schichtdicke von etwa 10 bis 100 µm, vorzugsweise etwa 20 µm, aufgebracht wird. Als Ausgangsstoff für die Herstellung der Paste 10 wird Silberpulver mit plättchenförmigen Pulverpartikeln, einer Korngröße kleiner oder gleich 15 µm und einer Schüttdichte von etwa 1,9 g/ml verwendet. Dieses Silberpulver wird in Cyclohexanol als Lösungsmittel im Gewichtsverhältnis von etwa 2 : 1 suspendiert. Anschließend wird die so hergestellte siebdruckfähige Paste 10 im Vakuum entgast, um beim Trocknen eine Lunkerbildung zu vermeiden. Die Paste 10 wird nach dem Auftragen durch Austreiben des Lösungsmittels getrocknet. Die Trockenzeit beträgt bei Raumtemperatur etwa 30 Minuten, bei höherer Temperatur jedoch nur wenige Minuten.

Nach dem Trocknen der Paste 10 werden das Substrat 1 und das Bauelement 3 auf eine Temperatur erwärmt, die mindestens 100°C beträgt, um die Paste vollständig zu trocknen. Vor oder nach diesem Vorwärmen wird das Bauelement 3 mit seiner Kontaktierungsschicht 9 auf die vollständig getrocknete Paste 10 des Substrats aufgesetzt.

Die aus den aufeinandergesetzten Teilen 1 und 3 gebildete Anordnung wird in eine metallische, topfförmige Aufnahmevorrichtung 11a, 11b (Fig. 2) eingelegt, die aus einem Bodenteil 11a und einem seitlichen Wandungsteil 11b besteht und in einer Ausnehmung 12 eines Pressenstempels 13 gelagert ist, der zu einer im einzelnen nicht dargestellten, insbesondere hydraulischen Presse gehört. Ein z.B. als Kreisring geformtes Teil 14 aus temperaturbeständigem, elastisch verformbaren Material, z.B. Silikonkautschuk oder einem anderen temperaturbeständigen, insbesondere fluorierten Elastomer, wird in die Aufnahmevorrichtung 11a, 11b mit eingelegt, so daß es die Anordnung 1, 3 gemäß Fig. 2 umgibt und vorzugsweise auch zentriert.

Ein weiteres, als Scheibe geformtes Teil 15 aus dem gleichen Material wie das Teil 14 oder aus einem anderen elastisch verformbaren Material wird sodann in den Innenraum der Aufnahmevorrichtung 11a, 11b so eingefügt, daß diesen nach oben abschließt. Dabei kann sich das Teil 15 auf der Oberseite des Teils 14 abstützen. In eine ringförmige Ausnehmung 16 des Teils 15 wird ein Dichtungsring 17, z.B. aus Metall, Keramik oder Kunststoff, eingelegt, der der Innenseite des seitlichen Wandungsteils 11b eng anliegt. Sodann wird die Aufnahmevorrichtung 11a, 11b durch Auflegen eines metallischen Stempels 18 auf den Dichtungsring 17 oder die Oberfläche des Teils 15 zu einer geschlossenen Aufnahmekammer ergänzt. Der Stempel 18 ist dabei in Richtung des Bodenteils 11a bewegbar gelagert. Er stützt sich gegen einen weiteren Pressenstempel 19 ab, der dem Stempel 13 gegenübersteht.

Der Pressenstempel 13 wird beheizt, so daß die Anordnung 1, 3 auf die gewünschte Sintertemperatur von beispielsweise 230°C erwärmt wird. Die Pressenstempel 13 und 19 werden durch Betätigung der Presse gegeneinander bewegt, so daß der Stempel 18 tiefer in den Innenraum der Aufnahmevorrichtung 11a, 11b eindringt, wobei sich die Teile 14 und 15 elastisch deformieren. Fig. 3 zeigt die Stellung der Pressenstempel 13 und 19, in der auf die Teile 1 und 3 ein für die Sinterung erforderlicher Druck von mindestens 900 N/cm² unter Aufrechterhaltung der Sintertemperatur ausgeübt wird. Dabei ist das Volumen der Teile 14 und 15 so bemessen, daß sie den vom Bauelement 3 und vom Substrat 1 nicht eingenommenen Innenraum der Aufnahmekammer 11a, 11b, 18 unter Vermeidung eines direkten Kontaktes zwischen dem Stempel 18 und dem Bauelement 3 vollständig ausfüllen. Auf diese Weise gelingt es, trotz der durch die unterschiedliche Höhe der Elektroden 6 und 7 und durch die Abschrägung 5 gegebenen Strukturierung der Bauelementoberfläche die Teile 1 und 3 über der gesamten Fläche 20, in der sie aufeinanderstoßen, mit konstantem Druck aufeinanderzupressen, so daß eine völlig gleichmäßige Verbindung der Teile erfolgt. Die elastische Deformation der Teile 14 und 15 ist dabei so groß, daß die Druckübertragung auf die Bauelementoberfläche völlig gleichmäßig ist, ohne daß jedoch Teile des elastisch verformbaren Materials in den zwischen den Teilen 1 und 3 bestehenden, durch die zusammengepreßte Paste 10 ausgefüllten Spalt eindringen. Damit wird eine einwandfreie Verbindung der Teile 1 und 3 auch im unmittelbaren Randbereich dieses Spalts erreicht. Das Austreten von Teilen des elastisch verformbaren Materials zwischen dem seitlichen Wandungsteil 11b und dem Stempel 18 wird zweckmäßigerweise durch den Dichtungsring 17 verhindert. Das vorstehend beschriebene Verhalten der elastisch deformierbaren Teile 14 und 15 kann als "quasi-hydrostatisch" bezeichnet werden.

Eine gute Verbindung der Teile 1 und 3 durch Drucksinterung wird dadurch erreicht, daß auf die Anordnung 1, 3 ein Druck von mindestens 900 N/cm² bei einer Sintertemperatur von z.B. 230°C während einer Sinterzeit von etwa 1 Minute ausgeübt wird. Es ist jedoch darauf hinzuweisen, daß bereits bei Sinterzeiten von einigen Sekunden ausreichende Ergebnisse erzielt werden und daß der Druck auch auf 1 bis 2 t/cm² gesteigert werden kann. Die Sintertemperaturen können in einem Bereich liegen, der einen unteren Grenzwert von etwa 150°C und einen oberen Grenzwert von etwa 250°C aufweist. Weiterhin ist hervorzuheben, daß das Drucksintern in normaler Atmosphäre vorgenommen wird, d.h. eine Anwendung von Schutzgas nicht erforderlich ist.

Nach dem Sintern wird die Anordnung 1, 3 aus der Aufnahmekammer 11a, 11b, 18 entfernt, wobei die Teile 14 und 15 wieder ihre ursprüngliche, in Figur 2 dargestellte Form annehmen. Sie stehen dann für die Drucksinterung von zahlreichen weiteren Bauelement-Substrat-Anordnungen zur Verfügung. Anstelle der bisher beschriebenen Teile 14 und 15, die kreisring- und plattenförmig ausgebildet sind, kann im Rahmen der Erfindung auch ein einziges Teil aus dem gleichen Material verwendet werden, sofern dessen Volumen dem der beiden Teile 14 und 15 entspricht.

Fig. 4 zeigt eine Variante der Anordnung nach den Figuren 2 und 3, bei der der in Richtung des Bodenteils 11a bewegbare Stempel 18 einen vorgezogenen Rand 21 aufweist, der das seitliche Wandungsteil 11b der Aufnahmevorrichtung umgreift. Fig. 4 zeigt entsprechend Fig. 2 jene Stellung der Pressenstempel 13 und 19, bei der noch kein Sinterdruck auf zwei in die Aufnahmevorrichtung 11a, 11b eingelegte Anordnungen 1, 3 und 1′, 3′ ausgeübt wird. Mit 1′ ist dabei ein weiteres Substrat bezeichnet, mit 3′ ein weiteres Halbleiterbauelement. Von Fig. 1 unterscheiden sich die Anordnungen 1, 3 und 1′, 3′ beispielsweise aber nicht zwangsläufig dadurch, daß die Bauelemente 3 und 3′ jeweils mit einem weiteren Substrat 1a bzw. 1a′ verbunden werden, und zwar im Bereich ihrer oberen Grenzflächen. Die Verbindungen mit den Substraten 1a und 1a′ erfolgen ebenfalls durch Drucksintern mittels entsprechender Pasten, die auf die die Spalte 20′ begrenzenden Kontakt- bzw. Kontaktierungsschichten aufgetragen und getrocknet werden. Durch die Elastizität der Teile 14 und 15, die in Fig. 4 im nicht deformierten Zustand dargestellt sind, ist es möglich, auch solche Anordnungen 1, 3 und 1′, 3′ in einem Preßvorgang druckzusintern, deren Bauelementabmessungen, insbesondere Bauelementhöhen, unterschiedlich sind. Bei der Anordnung nach Fig. 4 ist es zweckmäßig, das als Platte ausgebildete Teil 15 in den durch den vorstehenden Rand 21 gebildeten Innenraum des bewegbaren Stempels 18 einzulegen und durch den Dichtungsring 17a, der in einer Ausnehmung 16a liegt, in seiner Lage zu halten. Das Teil 14 ist hier zweckmäßigerweise als eine kreisförmige Scheibe ausgebildet, die mit Ausnehmungen für die Anordnungen 1, 3 und 1′, 3′ versehen ist. Mit Vorteil ist die Anordnung nach Fig. 4 so ausgebildet, daß der in Richtung des Bodenteils 11a bewegbare Stempel 18 aus einem Teil des Pressenstempels 19 besteht.

Der beschriebene Drucksintervorgang geht als Festkörperreaktion ohne das Auftreten flüssiger Phasen vor sich. Dabei eignet sich das beschriebene Verfahren insbesondere zum Befestigen von großflächigen, in MOS-Technologie hergestellten oder mit MOS-Strukturen versehenen Leistungshalbleitern auf Substraten.

Davon abgesehen werden mit dem erfinderischen Verfahren auch große Vorteile bei der Befestigung anderer elektronischer Bauelemente auf Substraten erzielt.

In Abweichung von den oben beschriebenen Ausgestaltungen des erfindungsgemäßen Verfahrens kann die aus einem Metallpulver und einem Lösungsmittel bestehende Paste 10 statt auf der Kontaktschicht 2 des Substrats 1 auf der Kontaktierungsschicht 9 des Bauelements 3 oder auch auf beiden Schichten 2 und 9 aufgetragen werden. Wesentlich ist bei allen diesen Varianten, daß die Teile 1 und 3 erst nach dem vollständigen Trocknen der Paste 10 aufeinandergelegt und druckgesintert werden, weil erst dadurch hohe Haftfestigkeiten und kleine elektrische Übergangswiderstände der Verbindungen erreicht werden.

## Patentansprüche

1. Verfahren zum Befestigen von elektronischen Bauelementen, insbesondere großflächigen Leistungshalbleitern, auf Substraten durch Drucksintern, bei dem eine aus einem Metallpulver und einem Lösungsmittel bestehende Paste (10) auf einer mit einer Kontaktierungsschicht (9) versehenen Grenzfläche eines Bauelements (3) und/oder auf einer Kontaktschicht (2) eines Substrats (1) aufgetragen wird, die aufgetragene Paste (10) vollständig getrocknet wird, das Bauelement (3) sodann mit seiner Grenzfläche auf die Kontaktoberfläche des Substrats (1) aufgesetzt wird und diese Anordnung in eine Presse eingebracht wird, in der sie bei Sintertemperatur mit einem Druck von mindestens 900 N/cm² zusammengepreßt wird, **dadurch gekennzeichnet,** daß
- das auf das Substrat (1) aufgesetzte Bauelement (3) in eine Aufnahmevorrichtung (11a, 11b) eingelegt wird, die aus einem Bodenteil (11a) und einem seitlichen Wandungsteil (11b) besteht und durch einen in Richtung des Bodenteils (11a) bewegbaren Stempel (18) zu einer geschlossenen Aufnahmekammer ergänzt wird, wobei sich das Bodenteil (11a) gegen einen ersten Pressenstempel (13) und der in Richtung des Bodenteils bewegbare Stempel (18) gegen einen zweiten Pressenstempel (19) abstützen,
- ein deformierbarer Körper (14, 15) aus temperaturbeständigem, elastisch verformbaren Material in die Aufnahmevorrichtung (11a, 11b) mit eingelegt wird,
- und das Volumen des deformierbaren Körpers (14, 15) so bemessen wird, daß er den vom Bauelement (3) und vom Substrat (1) nicht eingenommenen Innenraum der Aufnahmekammer (11a, 11b, 18) beim Erreichen des genannten Druckes unter Vermeidung eines direkten Kontaktes zwischen dem Stempel (18) und dem Bauelement (3) bzw. dem Substrat vollständig ausfüllt.

2. Anordnung zur Durchführung des Verfahrenes nach Anspruch 1, **dadurch gekennzeichnet,** daß eine Aufnahmevorrichtung (11a, 11b) vorgesehen ist, in die das auf das Substrat (1) aufgesetzte Bauelement (3) und der deformierbare Körper (14, 15) einlegbar sind, daß die Aufnahmevorrichtung aus einem Bodenteil (11a) und einem seitlichen Wandungsteil (11b) besteht und durch einen in Richtung des Bodenteils bewegbaren Stempel (18) zu einer geschlossenen Aufnahmekammer ergänzbar ist und daß die Aufnahmekammer in eine den Sinterdruck aufbringende Presse eingebracht ist, wobei sich das Bodenteil (11a) gegen einen ersten Pressenstempel (13) und der in Richtung des Bodenteils bewegbare Stempel (18) gegen einen zweiten Pressenstempel (19) abstützen.

3. Anordnung nach Anspruch 2, **dadurch gekennzeichnet,** daß der in Richtung des Bodenteils bewegbare Stempel (18) vom seitlichen Wandungsteil (11b) der Aufnahmevorrichtung umschlossen wird, und daß ein an der Innenseite des seitlichen Wandungsteils (11b) anliegender Dichtungsring (17) vorgesehen ist, der sich gegen den Rand des Stempels (18) abstützt.

4. Anordnung nach Anspruch 2, **dadurch gekennzeichnet,** daß der in Richtung des Bodenteils bewegbare Stempel (18) einen vorgezogenen Rand (21) aufweist, der das seitliche Wandungsteil (11b) der Aufnahmevorrichtung umgreift, und daß ein der Innenseite des vorgezogenen Randes (21) anliegender Dichtungsring (17a) vorgesehen ist, der sich gegen den Rand des seitlichen Wandungsteils (11b) der Aufnahmevorrichtung abstützt.

5. Anordnung nach Anspruch 3, **dadurch gekennzeichnet,** daß der deformierbare Körper (14, 15) zweiteilig ausgebildet ist, wobei das erste Teil (14) ringförmig ist und derart in die Aufnahmevorrichtung (11a, 11b) eingelegt wird, daß es das Bauelement (3) umgibt, und das zweite Teil (15) aus einer in den Innenraum der Aufnahmevorrichtung (11a, 11b) oberhalb des Halbleiterbauelements (3) einlegbaren Platte besteht.

6. Anordnung nach Anspruch 4, **dadurch gekennzeichnet,** daß der deformierbare (14, 15) Körper zweiteilig ausgebildet ist, wobei das erste Teil (14) ringförmig ist und derart in die Aufnahmevorrichtung (11a, 11b) eingelegt wird, daß es das Bauelement (3) umgibt, und das zweite Teil (15) aus einer Platte besteht, die in dem durch den vorstehenden Rand (21) gebildeten Innenraum des in Richtung des Bodenteils bewegbaren Stempels (18) angeordnet ist.

7. Anordnung nach einem der Ansprüche 2 bis 6, **dadurch gekennzeichnet,** daß der Pressenstempel (13), gegen den sich das Bodenteil (11a) abstützt, zur Erzeugung der Sintertemperatur beheizbar ist.

8. Anordnung nach einem der Ansprüche 2 bis 7, **dadurch gekennzeichnet,** daß der in Richtung des Bodenteils bewegbare Stempel (18) aus einem Teil des zweiten Pressenstempels (19) besteht.

9. Anordnung nach einem der Ansprüche 2 bis 8, **dadurch gekennzeichnet,** daß der deformierbare Körper (14, 15) aus Silikonkautschuk besteht.

10. Anordnung nach einem der Ansprüche 2 bis 8, **dadurch gekennzeichnet,** daß der deformierbare Körper (14, 15) aus einem temperaturbeständigen Elastomer besteht.

## Claims

1. Method of mounting electronic components, in particular large-area power semiconductors, on substrates by pressure sintering, in which a paste (10) comprising a metal powder and a solvent is applied to a boundary surface of a component (3), said boundary surface being provided with a contacting layer (9), and/or to a contact layer (2) of a substrate (1), the applied paste (10) is dried completely, the component (3) is then placed by means of its boundary surface on the contact surface of the substrate (1) and this arrangement is introduced into a press in which it is pressed together at sintering temperature with a pressure of at least 900 N/cm², characterized in that
- the component (3) placed on the substrate (1) is laid in a receiving device (11a, 11b) which comprises a base part (11a) and a lateral wall part (11b) and which is completed to form a closed receiving chamber by a ram (18) which can be moved in the direction of the base part (11a), the base part (11a) being braced against a first press ram (13) and the ram (18) which can be moved in the direction of the base part being braced against a second press ram (19),
- a deformable body (14, 15) composed of temperature-resistant, elastically deformable material also being laid in the receiving device (11a, 11b),
- and the volume of the deformable body (14, 15) being so dimensioned that it completely fills the interior space of the receiving chamber (11a, 11b, 18) not occupied by the component (3) and the substrate (1) when the said pressure is reached, direct contact being avoided between the ram (18) and the component (3) or the substrate.

2. Arrangement for carrying out the method according to Claim 1, characterized in that a receiving device (11a, 11b) is provided in which the component (3) placed on the substrate (1) and the deformable body (14, 15) can be laid, in that the receiving device comprises a base part (11a) and a lateral wall part (11b) and can be completed to form a closed receiving chamber by a ram (18) which can be moved in the direction of the base part, and in that the receiving chamber is introduced into a press which applies the sintering pressure, the base part (11a) being braced against a first press ram (13) and the ram (18) which can be moved in the direction of the base part being braced against a second press ram (19).

3. Arrangement according to Claim 2, characterized in that the ram (18) which can be moved in the direction of the base part is enclosed by the lateral wall part (11b) of the receiving device, and in that a sealing ring (17) is provided which is in contact with the inside of the lateral wall part (11b) and which is braced against the edge of the ram (18).

4. Arrangement according to Claim 2, characterized in that the ram (18) which can be moved in the direction of the base part has a salient edge (21) which fits round the lateral wall part (11b) of the receiving device, and in that a sealing ring (17a) is provided which is in contact with the inside of the salient edge (21) and which is braced against the edge of the lateral wall part (11b) of the receiving device.

5. Arrangement according to Claim 3, characterized in that the deformable body (14, 15) is constructed in two parts, the first part (14) being of annular design and being laid in the receiving device (11a, 11b) in such a way that it surrounds the component (3) and the second part (15) comprising a plate which can be laid in the interior space of the receiving device (11a, 11b) above the semiconductor component (3).

6. Arrangement according to Claim 4, characterized in that the deformable body (14, 15) is constructed in two parts, the first part (14) being of annular design and being laid in the receiving device (11a, 11b) in such a way that it surrounds the component (3) and the second part (15) comprising a plate which is disposed in the interior space, formed by the salient edge (21), of the ram (18) which can be moved in the direction of the base part.

7. Arrangement according to one of Claims 2 to 6, characterized in that the press ram (13) against which the base part (11a) is braced can be heated to generate the sintering temperature.

8. Arrangement according to one of Claims 2 to 7, characterized in that the ram (18) which can be moved in the direction of the base part comprises a part of the second press ram (19).

9. Arrangement according to one of Claims 2 to 8, characterized in that the deformable body (14, 15) comprises silicone rubber.

10. Arrangement according to one of Claims 2 to 8, characterized in that the deformable body (14, 15) comprises a temperature-resistant elastomer.

## Revendications

1. Procédé pour fixer des composants électroniques, notamment des semiconducteurs de puissance de surface étendue, sur des substrats, par frittage sous pression, dans lequel on dépose une pâte (10) constituée en une poudre métallique et en un solvant, sur une surface limite, pourvue d'une couche de contact (9), d'un composant (3) et/ou sur une couche de contact (2) d'un substrat (1), on fait sécher complètement la pâte déposée (10), on dépose ensuite le composant (3) par sa surface limite sur la surface de contact du substrat (1) et l'on insère cet ensemble dans une presse dans laquelle on le comprime à la température de frittage sous une pression d'au moins 900 N/cm², caractérisé par le fait que
- on insère le composant (3), qui est disposé sur le substrat (1), dans un dispositif de réception (11a, 11b), qui est constitué d'un élément de fond (11a) et d'un élément de paroi latéral (11b) et qu'on complète par un poinçon (18) déplaçable en direction de l'élément de fond (11a), pour former une chambre de logement fermée, la partie de fond (11a) prenant appui contre un premier poinçon de presse (13), tandis que le poinçon (18) déplaçable en direction de l'élément de fond prend appui contre un second poinçon de presse (19),
- on insère en même temps un corps déformable (14,15) en un matériau résistant à la température et déformable élastiquement, dans le dispositif de réception (11a, 11b), et
- on dimensionne le volume du corps déformable (14,15) de manière qu'il remplisse complètement l'espace intérieur, qui n'est pas occupé par le composant (3) et par le substrat (1), de la chambre de réception (11a, 11b, 18) lorsque ladite pression est atteinte, tout en empêchant un contact direct entre le poinçon (18) et le composant (3) ou le substrat.

2. Dispositif pour la mise en oeuvre du procédé suivant la revendication 1, caractérisé par le fait qu'il est prévu un dispositif de réception (11a, 11b), dans lequel le composant (3) disposé sur le substrat (1) et le corps déformable (14,15) peuvent être insérés, le dispositif de réception est constitué d'un élément de fond (11a) et d'un élément de paroi latéral (11b) et peut être complété par un poinçon (18) qui peut être déplacé en direction de l'élément de fond, pour former une chambre de réception fermée, et la chambre de réception est insérée dans une presse qui applique la pression de frittage, I'élément de fond (11a) prenant appui contre un premier poinçon de presse (13), tandis que le poinçon (18) déplaçable en direction de l'élément de fond, prend appui contre un second poinçon de presse (19).

3. Dispositif suivant la revendication 2, caractérisé par le fait que le poinçon (18), qui est déplaçable en direction de l'élément de fond, est entouré par l'élément de paroi latéral (11b) du dispositif de réception, et il est prévu une bague d'étanchéité (17), qui s'applique contre la face intérieure de l'élément de paroi latéral (11b) et qui prend appui contre le bord du poinçon (18).

4. Dispositif suivant la revendication 2, caractérisé par le fait que le poinçon (18), qui est déplaçable en direction de l'élément de fond, possède un bord saillant (21), qui entoure l'élément de paroi latéral (11b) du dispositif de réception, et il est prévu une bague d'étanchéité (17a), qui prend appui contre le bord de l'élément de paroi latéral (11b) du dispositif de réception et qui s'applique contre la face intérieure du bord saillant.

5. Dispositif suivant la revendication 3, caractérisé par le fait que le corps déformable (14,15) est formé de deux éléments, dont le premier (14) a une forme annulaire et est inséré dans le dispositif de réception (11a, 11b) de telle sorte qu'il entoure le composant (3), et dont le second (15) est constitué d'une plaque qui peut être insérée dans l'espace intérieur du dispositif de réception (11a, 11b) au-dessus du composant (3) à semiconducteurs .

6. Dispositif suivant la revendication 4, caractérisé par le fait que le corps déformable (14,15) est formé de deux éléments, dont le premier (14) a une forme annulaire et est inséré dans le dispositif de réception (11a, 11b) de telle sorte qu'il entoure le composant (3), et dont le second (15) est constitué d'une plaque, qui est disposée dans l'espace intérieur, formé par le bord saillant (21), du poinçon (18) déplaçable en direction de l'élément de fond.

7. Dispositif suivant l'une des revendications 2 à 6, caractérisé par le fait que le poinçon (13) de la presse, contre lequel prend appui l'élément de fond (11a), peut être chauffé pour l'obtention de la température de frittage.

8. Dispositif suivant l'une des revendications 2 à 7, caractérisé par le fait que le poinçon (18), qui est déplaçable en direction de l'élément de fond, est constitué d'une partie du second poinçon de presse (19).

9. Dispositif suivant l'une des revendications 2 à 8, caractérisé par le fait que le corps déformable (14,15) est en caoutchouc silicone.

10. Dispositif suivant l'une des revendications 2 à 8, caractérisé par le fait que le corps déformable (14,15) est en un élastomère résistant à la température.
